# EUROPEAN PATENT APPLICATION

(11) **EP 3 697 082 A1**
(43) Date of publication of application: **19.08.2020**
(21) Application number: 18898523.8
(22) Date of filing: 22.08.2018
(51) Int. Cl.: H04N 5/65, G09F 13/04, G09F 13/06

(54) **DISPLAY DEVICE AND ELECTRONIC DEVICE**

(30) Priority: 04.01.2018 KR 20180001307
(71) Applicant: Samsung Electronics Co., Ltd., Gyeonggi-do 16677 (KR)
(72) Inventor: SON, Chang-won, Gyeonggi-do 16677 (KR); JIN, Kyoung-shin, Gyeonggi-do 16677 (KR); KIM, Shin-a, Gyeonggi-do 16677 (KR); YOO, Ho-june, Gyeonggi-do 16677 (KR); YUN, Hyun-kyu, Gyeonggi-do 16677 (KR); SONG, Ho-kwon, Gyeonggi-do 16677 (KR); CHAE, Ho-suk, Gyeonggi-do 16677 (KR)
(74) Representative: Appleyard Lees IP LLP
(86) International application number: PCT/KR2018/009684
(87) International publication number: WO 2019/135461

(57) **Abstract**

A display device is disclosed. The display device comprises: a logo member formed on one side of a display and comprising a logo area on one side thereof; and a sensor disposed inside the logo member, wherein the sensor senses light incident on one surface of the logo member.

## Description

### [Technical Field]

The disclosure relates to a display device and an electronic device, more specifically to a display device including at least one sensor sensing light and an electronic device.

### [Background Art]

With the development of electronic technology, electronic products of various types are being development and supplied, and display devices providing a much wider display screen are becoming increasingly common. Specifically, the thickness of a display device bezel is becoming increasingly thinner in order to maintain a small size while providing a wide display screen.

However, mounting various components that are to be provided at a front surface part of the display device has become difficult due to design limitations and spatial limitations resulting from the thickness of the bezel growing thinner.

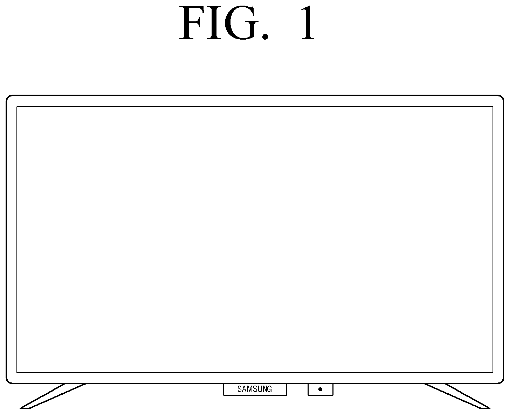

FIG. 1 is a diagram illustrating problems of a conventional display device mounted with various components.

Various sensors such as infrared (IR) sensor, illuminance sensor, color sensor, and the like are to be disposed within a member of a material capable of transmitting light separate from the bezel of the display device. In addition, because it is normal to receive a control signal from the front surface of the display device, some sensors are to be disposed to sense light from the front surface of the display device.

Accordingly, as illustrated in FIG. 1, a member disposed with a sensor at a side surface of a logo display at a lower end of the display device may be formed in a protruding form, and is disadvantageous for not showing the design of the display device in a complementary manner.

Recently, as display devices have become slimmer and the thickness of bezels thinner, the above-described disadvantages have become a more serious issue. Thus, there has been a need for developing a method for preventing sensing performance deterioration of various sensors without damaging the design of the display device.

### [Disclosure]

### [Technical Problem]

The disclosure is based on the above-described necessity, and an object of the disclosure is in providing a display device disposed with a sensor that does not harm the design and maintains sensing performance and an electronic device in order to solve the problem of mounting sensors being difficult as the bezels of the display devices grow thinner and sensing performances becoming deteriorated.

### [Technical Solution]

According to an embodiment, a display device includes a display, a logo member formed at one side of the display and including a logo area at one side of the logo member, and a sensor disposed inside of the logo member, and the sensor is configured to sense light incident through one surface of the logo member.

The logo area may be of a material that transmits the incident light, a background area other than the logo area of the one surface may be of a material that blocks the incident light, and the sensor may be disposed at a position corresponding to the logo area inside of the logo member.

The logo area may include at least one of a text area or a symbol area, and the position of the sensor may be identified base on a shape of at least one text included in the text area and a shape of at least one symbol included in the symbol area.

The sensor may include at least one of an IR sensor, a color sensor or an illuminance sensor, and the position of the sensor may be identified based on a size of the sensor.

The logo area may be of a material that blocks the incident light, a background area other than the logo area of the one surface may be of a material that transmits the incident light, and the sensor may be disposed at an area that is spaced apart from the one surface of the logo member inside of the logo member.

The one surface of the logo member may include particles with haze characteristics, and the incident light may be diffused into an inner part of the logo member by the particles included at the one surface.

The logo member may be formed at a lower side of the display, a light emitting device emitting light toward the lower side of the display may be included, a lower surface of the logo member may include a total reflection surface and a wedge structure including an emitting surface, light emitted toward the lower side direction may be totally reflected by the total reflection surface, and the totally reflected light may be emitted through the emitting surface.

On other areas other than the wedge structure of the lower surface, a button may be provided to control the display device.

The logo member may be formed at the lower side of the display, the logo member may include a shielding layer formed between a light emitting device emitting light toward the back direction of the display and the sensor to block the emitted light incident to the sensor, a back surface of the logo member may include an area that is protruded toward a lower side in one area of an edge contacting a lower surface of the logo member, the lower surface of the logo member may include a hole contacting the one area of an edge that is in contact with the back surface of the logo member, and the emitted light may pass through the hole and may be reflected by the protruded area.

According to an embodiment, an electronic device includes a main body, a logo member formed at one side of the main body and comprising logo area at one surface of the logo member, and a sensor disposed inside of the logo member, and the sensor is configured to sense incident light through one surface of the logo member.

The logo area may be of a material that transmits the incident light, a background area other than the logo area of the one surface may be of a material that blocks the incident light, and the sensor may be disposed at a position corresponding to the logo area inside of the logo member

The logo area may include at least one of a text area or a symbol area, and the position of the sensor may be identified based on a shape of least one text included in the text area and a shape of at least one symbol included in the symbol area.

The sensor may include at least one of an IR sensor, a color sensor or an illuminance sensor, and the position of the sensor may be identified based on the size of the sensor.

The logo area may be of a material blocking the incident light, a background area other than the logo area of the one surface may be of a material transmitting the incident light, and the sensor may be disposed at an area that is spaced apart from the one surface of the logo member inside of the logo member.

The one surface of the logo member may include particles with haze characteristics, and the incident light may be diffused into an inner part of the logo member by the particles included at the one surface.

The logo member may be formed at a lower side of the main body, a light emitting device emitting light toward a lower side direction of the main body may be included, the lower side surface of the logo member may include a total reflection surface and a wedge structure including an emitting surface, and the light emitted toward the lower side may be totally reflected by the total reflection surface and the totally reflected light may be emitted through the emitting surface.

On the area other than the wedge structure of the lower surface, a button may be provided to control the electronic device.

The logo member may be formed at the lower side of the main body, the logo member may include a shielding layer formed between a light emitting device emitting light toward the back direction of the display and the sensor to block the emitted light incident to the sensor, a back surface of the logo member may include an area that is protruded toward a lower side in one area of an edge contacting a lower surface of the logo member, the lower surface of the logo member may include a hole contacting the one area of an edge that is in contact with the back surface of the logo member, and the emitted light may pass through the hole and may be reflected by the protruded area.

### [Effect of Invention]

According to the various embodiments of the disclosure, the display device and the electronic device may be provided with a sensor at an inner part of the logo member thereby not harming the design, and a one surface of the logo member may include materials that transmit light thereby preventing deterioration of sensing performance.

### [Description of Drawings]

FIG. 1 is a diagram illustrating problems of a conventional display device mounted with various components;
FIG. 2A is an example of a block diagram illustrating a configuration of a display device;
FIG. 2B is a diagram illustrating an example of a display device including a logo member;
FIGS. 3A to 3C are diagrams illustrating various examples of a logo member form;
FIGS. 4A to 4C are diagrams illustrating various examples of a manufacturing method of a logo member;
FIGS. 5A to 5C are diagrams illustrating an example of a material of a logo member;
FIG. 6 is a diagram for illustrating an example of a position of a sensor when light is transmitted through a logo area;
FIGS. 7A and 7B are diagrams illustrating various examples of a position of a logo member on the display device;
FIGS. 8A and 8B are diagrams illustrating various examples of a logo member including an indicator;
FIGS. 9A and 9B are diagrams illustrating various examples of a button for controlling a display device; and
FIG. 10 is a diagram illustrating an example of an electronic device including a logo member.

### [Detailed Description of Exemplary Embodiments]

Various embodiments of the disclosure will be described in detail below with reference to the accompanying drawings.

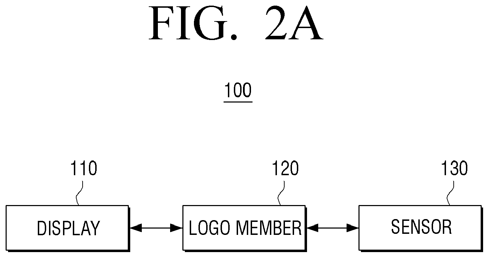

FIG. 2A is an example of a block diagram illustrating a configuration of a display device.

As illustrated in FIG. 2A, the display device 100, may include a display 110, a logo member 120 and a sensor 130.

The display device 100 may be of various display devices. For example, display device 100 may be implemented to various devices such as a television (TV), a monitor, a digital signage, a large format display (LFD), a display wall, a digital camera, an MP3 player, a portable media player (PMP), a smartphone, a cellular phone, a tablet personal computer (PC), and navigation. However, this is merely one embodiment, and the display device 100 may of any device that includes a display and a sensor.

The display 110 is configured to display an image processed by a processor (not shown). The display 110 may be implemented as a cathode ray tube (CRT), a liquid crystal display (LCD), a light emitting diode (LED), a plasma display panel (PDP), and the like, but is not limited thereto. In addition, in some cases, the display 110 may be implemented as a flexible display, a transparent display, and the like.

The logo member 120 may be formed at one side of the display 110. For example, the logo member 110 may be formed at a lower side of the display 110. However, the embodiment is not limited thereto, and the logo member 120 may be formed at a left side, a right side or an upper side of the display, and any position recognizable to a user in a front direction of the display. In addition, the logo member 120 may be formed to a form that is spaced apart by a predetermined distance from the display 110.

The logo member 120 may include a logo area at a one surface. For example, the logo member 120 may include the logo area at the one surface corresponding to a front direction of the display 110. The logo area refers to an area displayed with a logo herein.

The logo member 120 may be formed in various forms. For example, the logo member 120 may be in a cubic form with the upper side surface opened. In this case, the upper side surface of the logo member 120 may be connected to a lower side of the display 110. However, the embodiment is not limited thereto, and the logo member 120 may be in a cubic form without an opened surface. Alternatively, the logo member 120 may be a cube with the upper side surface opened, or a part of the side surface opened. As long as the one surface includes the logo area, the logo member 120 may be any form regardless of what form the other part excluding the one surface may be.

The sensor 130 may be disposed inside of the logo member. The sensor 130 may include at least one of the IR sensor, the color sensor, or the illuminance sensor. However, the embodiment is not limited thereto, and the sensor 130 may be any sensor so long as the sensor is capable of sensing light.

The sensor 130 may sense incident light through the one surface of the logo member 120. The sensor 130 may sense incident light to receive an IR signal transmitted from a remote control device, or detect light color, light direction, light illumination, and the like surrounding the display device 100.

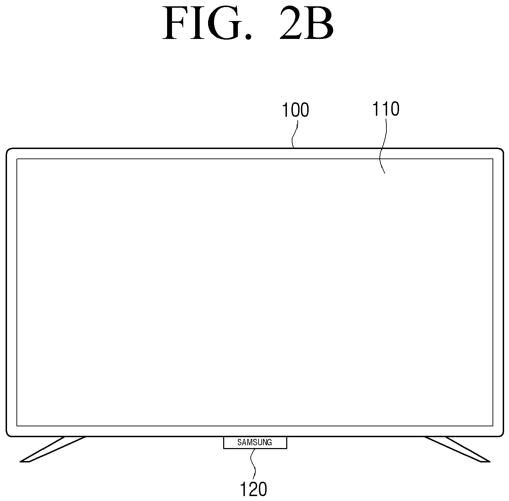

As illustrated in FIG. 2B, as the sensor 130 is disposed inside of the logo member 120, the user present at the front direction of the display device 100 may identify only the logo member 120, and the sensor 130 may not have to protrude at one side of the display device 100.

The configurations of the logo member 120 and the sensor 130 will be described in greater detail below through the drawings.

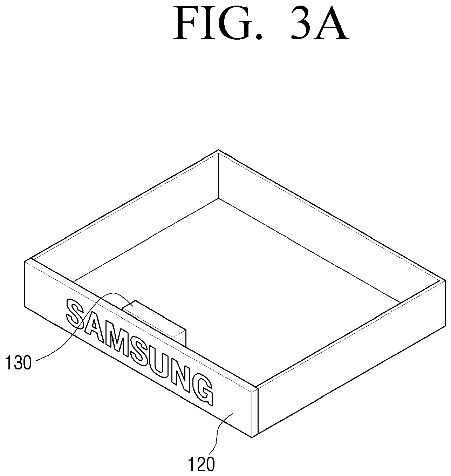

FIGS. 3A to 3C are diagrams illustrating various examples of a logo member 120 form.

The logo member 120 may include a logo area at a one surface. The one surface of the logo member 120 may be in a plane form as illustrated in FIG. 3A.

The sensor 130 may be disposed inside of the logo member 120. The placement position of the sensor 130 may be identified based on an area light is transmitted of the one surface of the logo member 120.

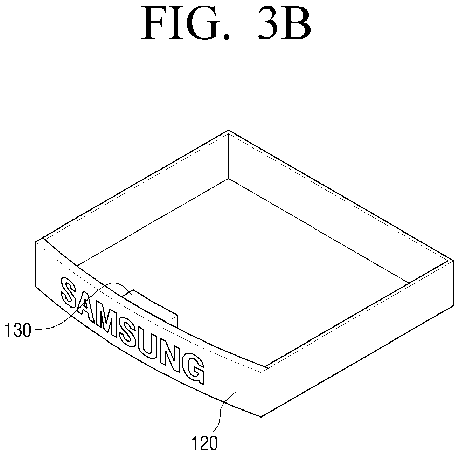

Alternatively, the one surface of the logo member 120 may be in a curved surface form. For example, the one surface of the logo member 120 may be in a form where the center part is concave as illustrated in FIG. 3B. In this case, the sensor 130 may also be in a concave form to correspond to the logo member 120.

However, the embodiment is not limited thereto, and the form of the sensor 130 may be modified according to a relative size of the logo member 120 and the sensor 130. For example, if the size of the sensor 130 is relatively smaller than the size of the logo member 120, the sensor 130 may be a form without a curved surface.

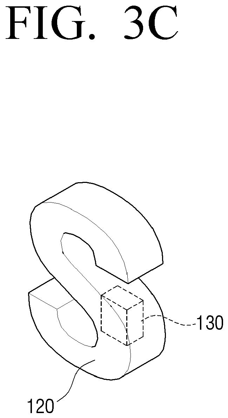

Alternatively, the logo member 120 may be a three-dimensional object in logo form. For example, the logo member 120 may be a three-dimensional object in a 'S' form as illustrated in FIG. 3C. In this case, the three-dimensional object may be of a material that transmits light, and the sensor 130 may be disposed at an inner part of the three-dimensional object.

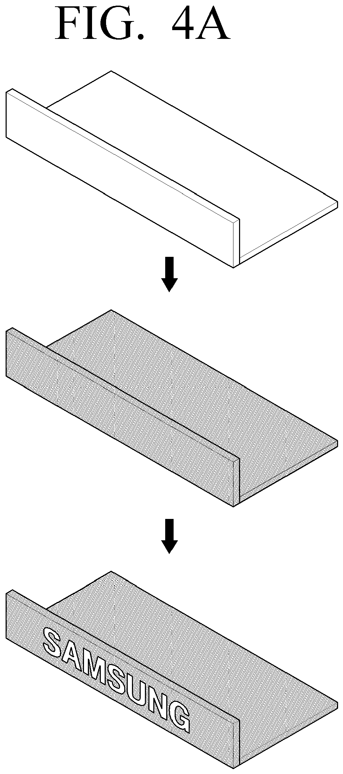

FIGS. 4A to 4C are diagrams illustrating various examples of a manufacturing method of a logo member 120. The one surface including the logo area of the logo member 120 may be transmitted with light. The light may be transmitted through the logo area or through a background area other than the logo area of the one surface.

FIG. 4A is a diagram for illustrating a method of forming a logo member 120 of a material that transmits incident light through the logo area and blocks light incident through a background area other than the logo area.

For example, as with the first diagram of FIG. 4A, a resin molded product may be formed. Next, as with the second diagram of FIG. 4A, the whole of the resin molded product may be painted a specific color. Next, as with the third diagram of FIG. 4A, the part to be used as logo area in the painted resin molded product may be laser engraved to form the logo member 120.

That is, the logo area may be in a paint stripped state with only the resin remaining, and the background area other than the logo area of the one surface may be in a painted state. Light may transmit the logo area formed of resin to reach the sensor 130 inside of the logo member 120. The painted background area may block light.

The sensor 130 may be disposed at a position corresponding to the logo area inside of the logo member 120. For example, because the logo area transmits light, the sensor 130 may be disposed in an adjacent state to the back direction of the logo area.

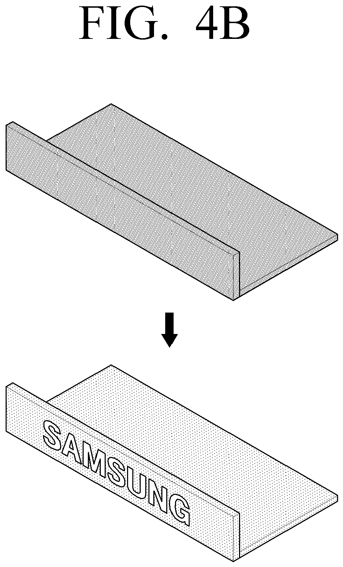

Alternatively, as with the first diagram of FIG. 4B, a resin molded product may be formed. Next, as with the second diagram of FIG. 4B, the remaining area excluding the part to be used as the logo area in the resin molded product may be painted to a specific color to form the logo member 120. In this case, whether light is transmitted, sensor placement, and the like is the same as in FIG. 4A, and thus redundant descriptions will be omitted.

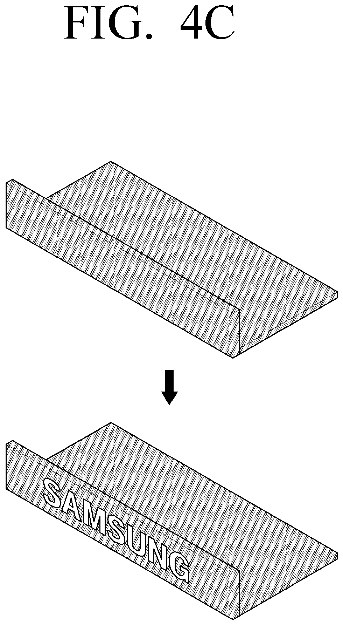

Alternatively, light may be transmitted through the background area. FIG. 4C is a diagram illustrating that the logo area may be of a material blocking incident light, and a method of the background area other than the logo area of the one surface forming the logo member 120 of a material that transmits incident light.

For example, as with the first diagram of FIG. 4C, a resin molded product may be formed. Next, as with the second diagram of FIG. 4C, the part to be used as the logo area in the resin molded product may be silk printed to a specific color to form the logo member 120.

That is, the logo area may be in a silk printed state, and the background area may be in a state with only the resin remaining. Light may transmit the background area formed of resin to reach the sensor 130 inside of the logo member 120. The silk printed logo area may block light.

The sensor 130 may be disposed at an area spaced apart from the one surface of the logo member 120 inside of the logo member 120. The background area transmitting light may be wider than the logo area, and if only the background area transmits light, the amount of light transmitted to the inner part of the logo member may be greater than if only the logo area transmits light. Accordingly, even if the sensor 130 is disposed at an area spaced apart from the one surface of the logo member 120, sensing performance may not be deteriorated.

In addition, since the background area is wider than the logo area, if the sensor 130 is disposed adjacent to the back direction of the background area, the sensor 130 may be visible to the user and harm the design. On the other hand, if the sensor 13 is disposed at an area spaced apart from the back direction of the background area, the issue of harming the design may not arise.

Although, FIGS. 4A to 4C have been described as using a resin molded product, the embodiment is not limited thereto. For example, the logo member 120 may be formed by a method of carving out the logo area on a metallic member. In addition, the empty space of the logo area may be filled with a material capable of transmitting light while covering the circuit material of the inner part of the logo member 120. In addition, other materials such as glass may be used in place of the resin molded product described above, and as long as the substance of the material is capable of transmitting light while covering the circuit material of the inner part of the logo member 120, the material may be any material. The meaning of covering the circuit material of the inner part of the logo material 120 may include the level of difficulty for the user to identify therein.

FIGS. 4A to 4C describe light as being transmitted through one of the logo area and the background area, but the embodiment is not limited thereto.

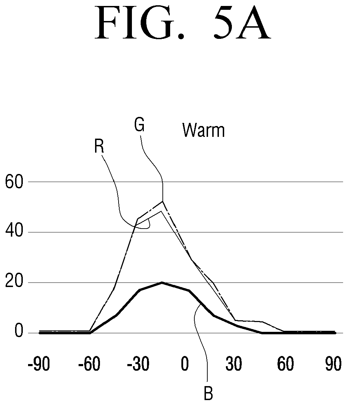

FIGS. 5A to 5C are diagrams illustrating an example of a material of a logo member 120. For example, the logo member 120 may be formed so that light is transmitted through the whole of the logo area and the background area.

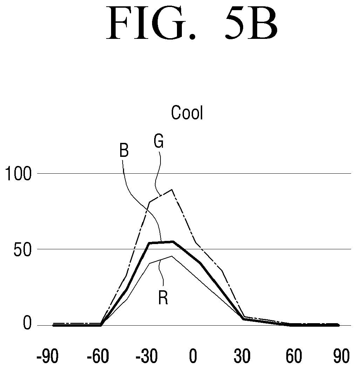

FIG. 5A is a diagram illustrating a sensing performance of a color sensor for each incident angle of light under a warm lighting if there is no resin, and FIG. 5B is a diagram illustrating a sensing performance of a color sensor for each incident angle of light under a cool lighting if there is no resin.

As illustrated in FIG. 5A and 5B, the sensing performance of the color sensor may change according to red color (R), green color (G), and blue color (B), the sensing performance of the color sensor may deteriorate as the incident angle of light becomes greater, and the sensing performance of the color sensor may be improved as the incident angle of light becomes smaller. That is, the color sensor may show optimum performance when light is incident from the front surface.

To this end, the one surface of the logo member 120 may include particles with haze characteristics. For example, if the logo member 120 is formed of resin, particles with haze characteristics may be included when injecting resin. In this case, incident light may be diffused toward the inner part of the logo member by the particles included in the one surface, and the sensor 130 disclosed inside the logo member 120 may be improved in sensing performance due to light receiving range broadening.

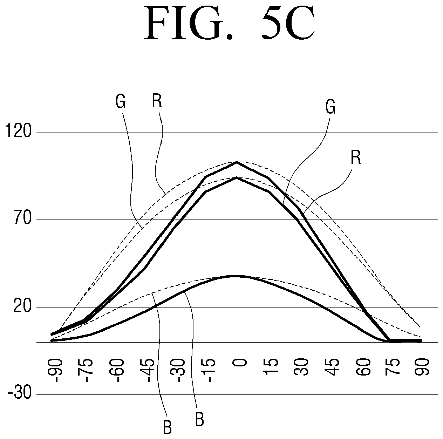

FIG. 5C is a diagram illustrating that the dotted line may be a cosine curve indicating an ideal sensing performance, and the solid line may indicate the sensing performance of the color sensor for each incident angle of light when a resin including particles with haze characteristics are present. FIG. 5C shows sensing performance having improved compared to that of FIGS. 5A and 5B.

Although a method of improving the sensor performance of the sensor 130 using material of the logo member 120 has been described in FIGS. 5A to 5C, the embodiment is not limited thereto. For example, sensing performance of the sensor 130 disposed inside of the logo member 120 may be improved by forming the area that transmits light from the one surface of the logo member 120 to a lens form. Alternatively, the logo member 120 may be formed of a material with high light transmittance.

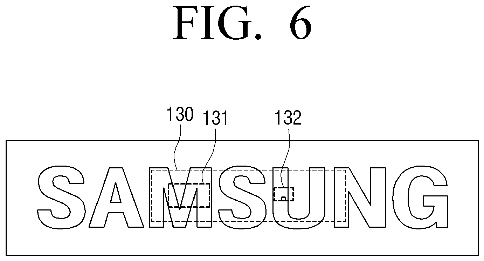

FIG. 6 is a diagram for illustrating an example of a position of a sensor 130 when light is transmitted through a logo area. When the sensor 130 senses light through the logo area, sensing performance may be deteriorated compared to when the sensor 130 is opened, and the sensor 130 may have to be disposed to an optimum position to make up for above.

As illustrated in FIG. 6, the position of the sensor 130 may be identified based on a shape of a text included in the logo area. For example, compared to other parts, the 'M' and the 'U' may be transmitted with a significant amount of light because of the area being relatively wider. In this case, the sensor 130 may be disposed at the back direction of the 'M' ad the 'U' to secure the amount of light.

Although only the text being included is illustrated in FIG. 6, the embodiment is not limited thereto. For example, the logo area may include at least one of a text area or a symbol area, and the position of the sensor 160 may be identified based on the shape of at least one text included in the text area and the shape of at least one symbol included in the symbol area.

In addition, the sensor 130 may include at least one of an IR sensor, a color sensor or an illuminance sensor, and the location of the sensor 130 may be identified based on the size of the sensor. For example, as illustrated in FIG. 6, the sensor 130 may include an IR sensor 311 and an color sensor 132, and the IR sensor 131 which is larger in size than the color sensor 132 may be disposed at the back direction of the 'M' to secure a more significant amount of light, and the color sensor 132 may be disposed at the back direction of the 'U'.

Although, in FIG. 6, the sensor 130 has been described as being disposed at area with a wide surface area in the logo area, the embodiment is not limited thereto. For example, if the surface area is too wide, the sensor 130 may be visible to the user. Accordingly, the sensor 130 may be disposed at the back direction of the widest surface area of the areas that are difficult to identify by the user.

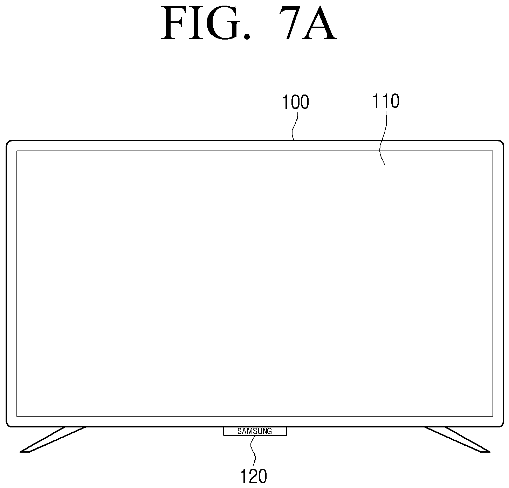

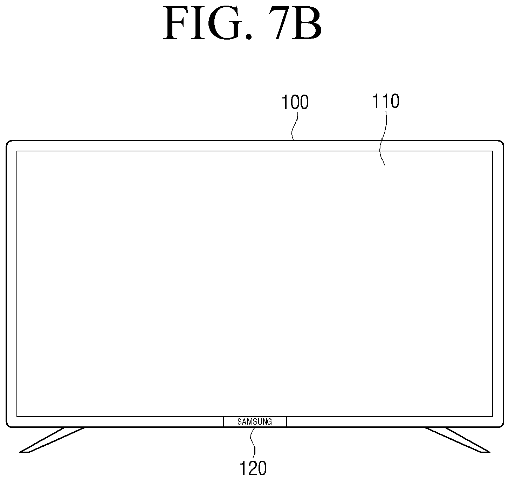

FIGS. 7A and 7B are diagrams illustrating various examples of a position of a logo member 120 on the display device 100.

As illustrated in FIG. 7A, the logo member 120 may be formed at the lower side of the display 110. The display may include a screen and a bezel, and the logo member 120 may be formed in a protruding form at the lower side of the bezel.

In FIG. 7A, the logo member 120 has been described as being formed at the lower part of the display 110, but the embodiment is not limited thereto. For example, the logo member 120 may be formed at a left side, a right side, or an upper side of the display 110.

In FIG. 7A, the logo member 120 has been described as being added to the display, but the embodiment is not limited thereto. For example, as illustrated in FIG. 7B, a part of the bezel of the display 110 may be formed as the logo area. In this case, the sensor 130 may be disposed at the inner part of the bezel of the display 110.

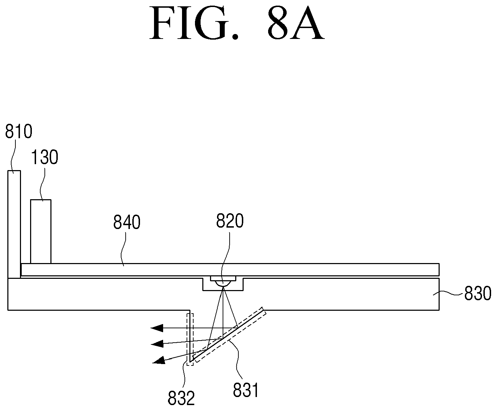

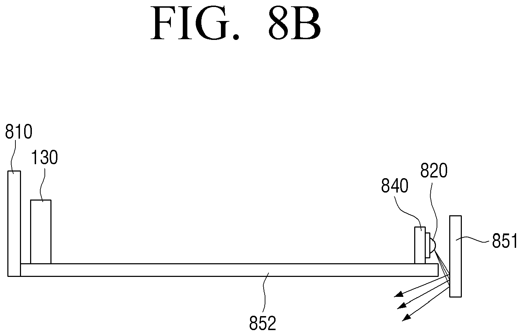

FIGS. 8A and 8B are diagrams illustrating various examples of a logo member 120 including an indicator. The indicator is a configuration for providing a state of the display device 100, and the like. For example, the indicator may be configured to emit a green colored light to indicate that the display device 100 is in a turned on state, and emit a red colored light to indicate that the display device 100 is in a turned off state. When forming the indicator, securing visibility and securing a waterproof and dustproof function for the protection of circuitry may be important.

FIG. 8A illustrates an example of a side view of the logo member 120, and illustrates the one surface 810 including the logo area at the left side and the sensor 130 disposed inside the logo member 120. The logo member 120 may be formed at the lower side of the display 110, may include a light emitting device 820 emitting light toward the lower side direction of the display 110, and the lower surface 830 of the logo member 120 may include a total refection surface 831 and a wedge structure including an emitting surface 832. The lower surface 830 of the logo member 120 may be a transparent or translucent molded product, and the light emitting device 820 and the lower surface 830 may be configured to form the indicator. Waterproofing and dustproofing of the circuitry of the inner part of the logo member 120, the indicator, and the like may be possible as the lower surface 830 is formed as a molded product, and the circuitry may be protected from electrical influences such as an electrostatic discharge.

Light emitted toward the lower side direction from the light emitting device 820 may be totally reflected by the total reflection surface 831, and the totally reflected light may be emitted through the emitting surface 832. The light emitting device 80 may be a light emitting diode (LED), but the embodiment is not limited thereto, and any configuration capable of emitting light may be possible.

The total reflection surface 831 may be surface treated to raise the reflection rate of the emitted light toward the lower side direction from the light emitting device 820. The emitting surface 832 may be surface treated so that light totally reflected from the total reflection surface 831 is emitted toward the front surface.

In addition, the logo member 120 may further include a shielding layer 840 formed at the upper part of the light emitting device 820 and at the lower part of the sensor 130. The shielding layer 840 may prevent light emitted from the light emitting device 820 from being introduced to the sensor 130.

FIG. 8B illustrates another example of a side view of the logo member 120, and illustrates the one surface 810 including the logo area at the left side and the sensor 130 disposed inside the logo member 120.

The logo member 120 may be formed at the lower side of the display 110. In addition, the logo member 120 may be formed between the light emitting device 820 emitting light toward the back direction of the display 110 and the sensor 130, and may include a shielding layer 840 that blocks emitted light incident to the sensor 130.

The back surface 851 of the logo member 120 may include an area protruded from one area of an edge that is in contact with the lower surface 852 of the logo member 120 to the lower side, and the lower surface 852 of the logo member 120 may include a hole contacting one area of the edge that is in contact with the back surface 851 of the logo member 120.

The light emitted from the light emitting device 820 may pass through the hole to be reflected by the protruded area.

In FIG. 8B, the area protruded toward the lower side of the back surface 851 of the logo member 120 may be illustrated as extending from the back surface 851 of the logo member 120 in a straight line, but the embodiment is not limited thereto. For example, the protruded area may be formed at a 45-degree angle with the lower surface 852 of the logo member 120. In this case, the light emitted from the light emitting device 820 may be reflected by the protruded area toward the front direction than the protruded area being extended from the back surface 851 of the logo member 120 in a straight line.

In FIGS. 8A and 8B, the logo member 120 being formed at the lower side of the display 110 has been described as an example, but the position of the light emitting device 820 and the like may be changed based on the relative position with respect to the display 100 of the logo member 120.

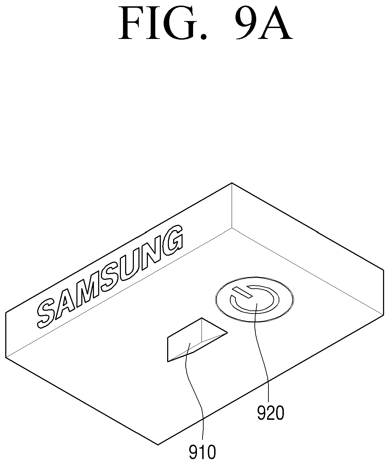

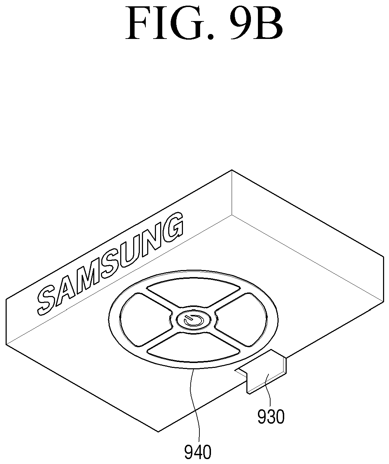

FIGS. 9A and 9B are diagrams illustrating various examples of a button for controlling a display device 100.

FIG. 9A illustrates an example of a wedge structure 910 formed at the lower surface of the logo member 120, and the logo member 120 may further include a button 920 for controlling the display device 100 at an area other than the wedge structure 910 of the lower surface.

For example, the button 920 may be formed at a side surface area of the wedge structure 910 of the lower surface to a one-button form. However, the embodiment is not limited thereto, and the wedge structure 910 may be formed at the back direction of the lower surface, and a button may be formed at the center part of the lower surface. In addition, a plurality of buttons may be formed at the lower surface.

FIG. 9B illustrates an example of a hole and a protruded area 930 of the back surface being formed at the lower surface of the logo member 120, and the logo member 120 may further include a plurality of buttons 940 for controlling the display device 100 at the lower surface.

For example, the button 940 may be formed in a 4-directional button form and a confirm button form at the center part of the lower surface.

According to FIGS. 9A and 9B, the wedge structure or the protruded area of the back surface has been illustrated a being formed only at the one area of the lower surface and the one area of the back surface, respectively, but this is merely one embodiment. For example, the wedge structure or the protruded area of the back surface may be formed to correspond with the whole width of the lower surface and the whole width of the back surface, respectively.

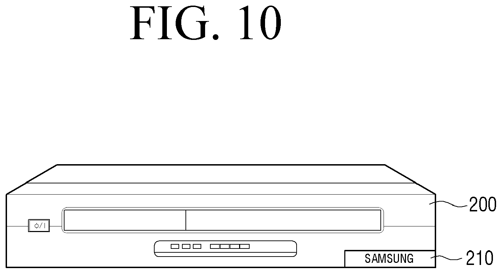

FIG. 10 is a diagram illustrating an example of an electronic device 200 including a logo member.

As illustrated in FIG. 10, the electronic device 200 includes a main body, a logo member 210 formed at one side of the main body and including a logo area at a one surface, and a sensor disposed inside of the logo member 210, and the sensor may be configured to sense incident light through the one surface of the logo member 210.

In addition, the logo area may be of a material that transmits incident light, a background area other than the logo area of the one surface may be of a material that blocks incident light, and the sensor may be disposed at a position corresponding to the logo area inside of the logo member 210.

The logo area may include at least one of a text area or a symbol area, and the position of the sensor may be identified base on a shape of at least one text included in the text area and a shape of at least one symbol included in the symbol area.

The sensor may include at least one of an IR sensor, a color sensor, or an illuminance sensor, and the position of the sensor may be identified based on the size of the sensor.

Alternatively, the logo area may be of a material that blocks incident light, the background area other than the logo area of the one surface may be of a material that transmits incident light, and the sensor may be disposed at an area spaced apart from the one surface of the logo member 210 inside of the logo member 210.

The one surface of the logo member 210 may include particles with haze characteristics, and the incident light may be diffused toward an inner part of the logo member 210 by particles included at the one surface.

The logo member 210 may be formed at the lower side of the main body, a light emitting device emitting light toward the lower wide direction of the main body may be included, the lower surface of the logo member 210 includes a wedge structure including a total reflection surface and an emitting surface, light emitted toward the lower side direction may be totally reflected by the total reflection surface, and the totally reflected light may be emitted through the emitting surface.

A button may be provided for controlling the electronic device 200 at an area other than the wedge structure of the lower surface.

Alternatively, the logo member 210 may be formed at the lower side of the main body, the logo member 210 may include a shielding layer formed between the light emitting device emitting light toward the back direction of the main body and the sensor to block emitted light incident to the sensor, and the back surface of the logo member 210 may include an area protruded toward the lower side from the one area of an edge that is in contact with the lower surface of the logo member 210, the lower surface of the logo member 210 may include a hole contacting the one area of the edge that is in contact with the back surface of the logo member, and the emitted light may pass through the hole to be reflected by the protruded area.

In addition thereto, if there is an embodiment that does not require a display from the embodiments described in FIGS. 2A to 9B, the embodiment may be applicable to the electronic device 200.

According to the various embodiments of the disclosure as described above, the display device and the electronic device may be provided with a sensor at the inner part of the logo member thereby not harming the design, and the one surface of the logo member may include a material that transmits light to prevent deterioration of sensing performance.

In addition, the logo member may, based on including an indicator of the wedge structure, secure a waterproof and dustproof function and protect circuitry from electrostatic discharge. In addition, the lower surface of the logo member may be a transparent or a translucent molded product, and thus the user may not be able to identify the circuitry, and the like of the inner part of the logo member.

In the drawings above, although the one surface of the logo member has been described as including a logo area designated as 'SAMSUNG', this is merely one embodiment, and the same technology may also be applicable to the logo area including any other texts, symbols, and the like.

In addition, the logo member may include only the indicator without the sensor. For example, a logo member may include a logo area at a one surface, a lower surface of the logo member may include a wedge structure, and the logo member may include a light emitting device emitting light to the wedge structure.

In addition, the logo member may only include the sensor without the indicator, and the sensor may sense the light through the wedge structure. For example, the lower surface of the logo member may include the wedge structure, and the sensor may be formed at the upper part of the wedge structure facing the lower side of the logo member. In this case, the IR signal and the like emitted from a remote control device may be incident toward the inner part of the wedge structure through the emitting surface of the wedge structure, and the incident IR signal may be totally reflected toward the sensor direction through the total reflection surface. The sensor facing the lower side may receive the IR signal totally reflected through the wedge structure.

In addition, although the light emitting device in the logo member above has been described as emitting light through the lower side of the logo member, the embodiment is not limited thereto. For example, even if the logo member is formed at the lower part of the display, the light emitting device may emit light through the side surface of the logo member.

While various embodiments have been illustrated and described, the disclosure is not limited to specific embodiments or the drawings, and it will be understood by those of ordinary skill in the art that various changes in form and details may be made therein without departing from the spirit and scope as defined.

## Claims

1. A display device, comprising:
a display;
a logo member formed at one side of the display, and comprising a logo area at one side of the logo member; and
a sensor disposed inside of the logo member,
wherein the sensor is configured to sense incident light through one surface of the logo member.

2. The display device of claim 1, wherein the logo area is of a material that transmits the incident light,
wherein a background area other than the logo area of the one surface is of a material that blocks the incident light, and
wherein the sensor is disposed at a position corresponding to the logo area inside of the logo member.

3. The display device of claim 2, wherein the logo area comprise at least one of a text area or a symbol area, and
wherein the position of the sensor is identified based on a shape of at least one text comprised in the text area and a shape of at least one symbol comprised in the symbol area.

4. The display device of claim 3, wherein the sensor comprises at least one of an infrared (IR) sensor, a color sensor or an illuminance sensor, and
wherein a position of the sensor is identified based on a size of the sensor.

5. The display device of claim 1, wherein the logo area is of a material that blocks the incident light,
wherein a background area other than the logo area of the one surface is of a material that transmits the incident light, and
wherein the sensor is disposed at an area spaced apart from the one surface of the logo member inside of the logo member.

6. The display device of claim 1, wherein the one surface of the logo member comprises particles with haze characteristics, and
wherein the incident light is diffused toward an inner part of the logo member by particles comprised in the one surface.

7. The display device of claim 1, wherein the logo member comprises a light emitting device formed at a lower side of the display and emitting light toward a lower side direction of the display,
wherein the lower surface of the logo member comprises a wedge structure comprising a total reflection surface and an emitting surface, and
wherein light emitted toward the lower side direction is totally reflected by the total reflection surface, and the totally reflected light is emitted through the emitting surface.

8. The display device of claim 7, wherein a button for controlling the display device is provided at an area other than the wedge structure of the lower surface.

9. The display device of claim 1, wherein the logo member is formed at a lower side of the display,
wherein the logo member comprises:
a light emitting device emitting light toward a back direction of the display; and
a shielding layer formed between the sensor and the light emitting device, and blocking the emitted light incident to the sensor,
wherein a back surface of the logo member comprises an area protruded from one area of an edge that is in contact with a lower surface of the logo member to the lower side,
wherein a lower surface of the logo member may include a hole contacting the one area of the edge that is in contact with the back surface of the logo member, and
wherein the emitted light passes through the hole to be reflected by the protruded area.

10. An electronic device, comprising:
a main body;
a logo member formed at one side of the main body, and comprising a logo area at one surface of the logo member; and
a sensor disposed inside of the logo member,
wherein the sensor is configured to sense incident light through one surface of the logo member.

11. The electronic device of claim 10, wherein the logo area is of a material that transmits the incident light,
wherein a background area other than the logo area of the one surface is of a material that blocks the incident light, and
wherein the sensor is disposed at a position corresponding to the logo area inside of the logo member.

12. The electronic device of claim 11, wherein the logo area comprises at least one of a text area or a symbol area, and
wherein a position of the sensor is identified based on a shape of at least one text comprised in the text area and a shape of at least one symbol comprised in the symbol area.

13. The electronic device of claim 12, wherein the sensor comprises at least one of an IR sensor, a color sensor or an illuminance sensor, and
wherein a position of the sensor is identified based on a size of the sensor.

14. The electronic device of claim 10, wherein the logo area is of a material that blocks the incident light,
wherein a background area other than the logo area of the one surface is of a material that transmits the incident light, and
wherein the sensor is disposed at an area spaced apart from a one surface of the logo member inside of the logo member.

15. The electronic device of claim 10, wherein the one surface of the logo member comprises particles with haze characteristics, and
wherein the incident light is diffused toward an inner part of the logo member by particles comprised in the one surface.
